(19)

Europäisches
Patentamt
European
Patent Office
Office européen
des brevets

(11) **EP 4 503 376 A1**

(12) **EUROPEAN PATENT APPLICATION**

(43) Date of publication:
**05.02.2025 Bulletin 2025/06**

(21) Application number: **24185930.5**

(22) Date of filing: **02.07.2024**

(51) International Patent Classification (IPC):
*H02J 7/00* (2006.01)    *H01M 10/44* (2006.01)

(52) Cooperative Patent Classification (CPC):
**H02J 7/00712; H01M 4/386; H01M 10/44;
H02J 7/007182; H02J 7/007188**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **01.08.2023 KR 20230100660**

(71) Applicant: **SAMSUNG SDI CO., LTD.
Giheung-gu
Yongin-si, Gyeonggi-do
17084 (KR)**

(72) Inventor: **JUNG, Mijung
17084 Yongin-si (KR)**

(74) Representative: **Marks & Clerk LLP
15 Fetter Lane
London EC4A 1BW (GB)**

(54) **BATTERY MANAGEMENT SYSTEM AND METHOD FOR CHARGING BATTERY**

(57)    A method for charging a battery, includes: charging a battery cell with a first C-rate within a range from an initial charge voltage to a first charge voltage; and charging the battery cell with a second C-rate to an N-th C-rate, which are smaller than first C-rate and different from each other, so that a thickness change rate of the battery cell is a threshold value or less within a range from the first charge voltage to a second charge voltage, where N is an integer greater than or equal to 3.

## FIG. 2

S201 — Charging battery cell with first C-rate within range from initial charge voltage to first charge voltage

S202 — Charging battery cell with second C-rate to N-th C-rate that are smaller than first C-rate and different from each other so that thickness change rate of battery cell is a threshold value or less within range from first charge voltage to second charge voltage

EP 4 503 376 A1

**Description**

**BACKGROUND**

**1. Field**

Aspects of embodiments of the present disclosure relate to a battery management system, and a method for charging a battery.

**2. Description of the Related Art**

Recently, as technology development and demand for portable devices, such as portable computers, portable phones, and cameras, have been increasing, demand for rechargeable batteries as an energy source is rapidly increasing. As the rechargeable batteries may be recharged and used again even after discharging, and because differences may appear in performance depending on the states of the charge and discharge, improved charging methods may be desired in order to improve the performance of the rechargeable batteries. Additionally, to increase energy density, it may be desirable to increase a silicon content of a negative electrode.

If the silicon content of the negative electrode is increased, problems such as plate expansion, plate detachment, and cycle-life deterioration may occur during high-rate charging. To prevent these problems, attempts are being made to apply a nanosized silicon and increased binder content, but there can be problems such as a deterioration of the energy density or the high-rate charging performance.

The above information disclosed in this Background section is for enhancement of understanding of the background of the present disclosure, and therefore, it may contain information that does not constitute prior art.

**SUMMARY**

Embodiments of the present disclosure are directed to a battery management system and a method for charging a battery such that expansion of a negative electrode may be reduced by using high-content silicon, and life-cycle may be improved.

According to one or more embodiments of the present disclosure, a method for charging a battery, includes: charging a battery cell with a first C-rate within a range from an initial charge voltage to a first charge voltage; and charging the battery cell with a second C-rate to an N-th C-rate, which are smaller than first C-rate and different from each other, so that a thickness change rate of the battery cell is a threshold value or less within a range from the first charge voltage to a second charge voltage, where N is an integer greater than or equal to 3. In other words, the thickness change rate of the battery cell stays at the threshold value or at a rate that is less than the threshold value (i.e. it does not exceed the threshold value) during the charging at the second to N-th C-rates.

In an embodiment, the charging of the battery cell with the second C-rate to the N-th C-rate may include: charging the battery cell with an i-th C-rate, where i may be greater than or equal to 2 and less than or equal to N-1; and charging the battery cell with an (i+1)-th C-rate that is smaller than the i-th C-rate.

In an embodiment, the charging of the battery cell with the i-th C-rate and the charging of the battery cell with the (i+1)-th C-rate may be sequentially performed.

In an embodiment, the first charge voltage may be in a range of 4.08V to 4.1V.

In an embodiment, the second charge voltage may be in a range of 4.2V to 4.25V.

In an embodiment, the thickness change rate of the battery cell may be a ratio of a difference between a first thickness of the battery cell, measured while applying a pressure to the battery cell at the initial charge voltage, and a second thickness of the battery cell, measured while applying a pressure to the battery cell at the second charge voltage, to the first thickness of the battery cell. The pressures can be a certain, specific or predetermined pressure (e.g. the same for both).

In an embodiment, the battery cell may include a negative electrode including 80% or more of a silicon-based active material, or 50% or more of silicon.

In an embodiment, the initial charge voltage may be in a range of 3.0V to 3.1V.

In an embodiment, the thickness change rate of the battery cell may be 65% or less.

In an embodiment, the charging of the battery cell with the first C-rate and the charging of the battery cell with the second C-rate to the N-th C-rate may include charging the battery cell by a constant-current (CC) charging method.

According to one or more embodiments of the present disclosure, a battery management system includes: a first charger (or first charge unit) configured to charge a battery cell with a first C-rate within a range from an initial charge voltage to a first charge voltage; and a second charger (or second charge unit) configured to charge the battery cell from a second C-rate to an N-th C-rate, which are smaller than the first C-rate and different from each other, so that a thickness change rate of the battery cell is a threshold value or less within a range from the first charge voltage to a second charge voltage. In one or more embodiment, N is an integer of 3 or more.

In an embodiment, the second charger may be configured to charge the battery cell with an i-th C-rate, where i may be greater than or equal to 2 and less than or equal to N-1, and to charge the battery cell with an (i+1)-th C-rate smaller than the i-th C-rate.

In an embodiment, the second charger may be configured to sequentially charge the battery cell with the i-th C-rate and the (i+1)-th C-rate.

In an embodiment, the first charge voltage may be in a range of 4.08V to 4.1V.

In an embodiment, the second charge voltage may be in a range of 4.2V to 4.25V.

In an embodiment, the thickness change rate of the battery cell may be a ratio of a difference between a first thickness of the battery cell, measured while applying a pressure to the battery cell at the initial charge voltage, and a second thickness of the battery cell, measured while applying a pressure to the battery cell at the second charge voltage, to the first thickness of the battery cell. As before, the pressures can be a certain, specific or predetermined pressure (e.g. the same for both).

In an embodiment, the battery cell may include a negative electrode including 80% or more of a silicon-based active material, or 50% or more of silicon.

In an embodiment, the initial charge voltage may be in a range of 3.0V to 3.1V.

In an embodiment, the thickness change rate of the battery cell may be 65% or less.

In an embodiment, the first charger and the second charger may be configured to charge the battery cell by a constant-current (CC) charge method.

According to one or more embodiments of the present disclosure, when charging at high rates, by lowering an overvoltage through a step-by-step process charging method, the deterioration of the silicon negative electrode may be suppressed, the rapid expansion of the silicon negative electrode may be reduced, the battery life-cycle may be improved, and/or the energy density and high-rate charging performance of the battery having high-content silicon may be prevented or substantially prevented from being deteriorated.

At least some of the above and other features of the invention are set out in the claims.

**BRIEF DESCRIPTION OF THE DRAWINGS**

The above and other aspects and features of the present disclosure will be more clearly understood from the following detailed description of the illustrative, nonlimiting embodiments with reference to the accompanying drawings.

FIG. 1 is a block diagram schematically showing a battery management system according to an embodiment.
FIG. 2 is a flowchart showing a method for charging a battery according to an embodiment.
FIG. 3 is a graph showing a change in a current according to an SOC of a battery cell.
FIG. 4 is a graph showing a change in a voltage according to an SOC of a battery cell.

**DETAILED DESCRIPTION**

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

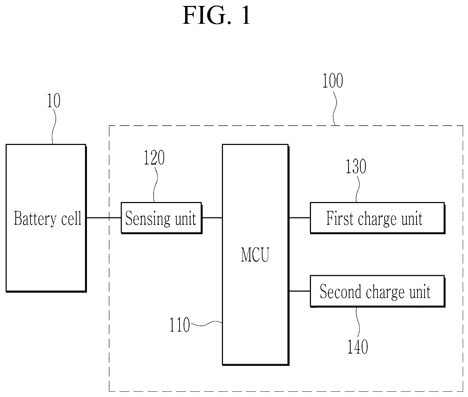

FIG. 1 is a block diagram schematically showing a battery management system according to an embodiment.

Referring to FIG. 1, a battery management system 100 may include a micro control unit (MCU) 110 (e.g., a microcontroller), a sensing unit 120 (e.g., a sensor, a sensing circuit, or a sensing device), a first charge unit 130 (e.g., a first charger, a first charge circuit, or a first charge device), and a second charge unit 140 (e.g., a second charger, a second charge circuit, or a second charge device).

The MCU 110 may play a role in managing and controlling the overall charging and discharging of the battery cell 10.

The sensing unit 120 may measure the output current and voltage of the battery cell 10 by using a sensor, and may calculate a state of charge (SOC).

The first charge unit 130 may charge the battery cell 10 with a first C-rate within a range from an initial charge voltage to a first charge voltage. The C-rate may be a current rate, which is a unit for setting a current value under various usage conditions when charging and discharging the battery, and for predicting and indicating a possible use time of the battery. The C-rate may be calculated by dividing the charge or discharge current by the battery's rated capacity. The unit of the C-rate may use C, and may be defined by Equation 1 below.

Equation 1:

$$C - \text{rate}(C) = \frac{\text{charge/discharge current}}{\text{rated capacity of battery}}$$

A thickness change rate of the battery cell 10 may be a ratio of a difference between a first thickness of the battery cell measured while applying a certain pressure to the battery cell at the initial charge voltage and a second thickness of the battery cell measured while applying a certain pressure to the battery cell at a second charge voltage to the first thickness of the battery cell.

In other words, the thickness change rate of the battery cell 10 may be a value measured when a pressure (e.g., a specific or predetermined pressure) is applied to the battery cell, and may be defined by Equation 2 below.

Equation 2:

$$\text{Thickness change rate (\%)} =$$

$$\frac{\text{thickness of battery cell at second charge voltage} - \text{thickness of battery cell at initial charge voltage}}{\text{thickness of battery cell at initial charge voltage}} \times 100$$

The first charge unit 130 may use the data measured by the sensing unit 120.

The second charge unit 140 may charge the battery cell 10 in stages from a second C-rate to an N-th C-rate (where N is an integer of 3 or more) within the range from the first charge voltage to the second charge voltage for the thickness change rate of the battery cell 10 to be within a threshold value or less. The second C-rate to the N-th C-rate may be smaller than the first C-rate, and may be different from each other. Additionally, the C-rate may decrease sequentially from the first C-rate to the N-th C-rate.

The second charge unit 140 may use the data measured by the sensing unit 120.

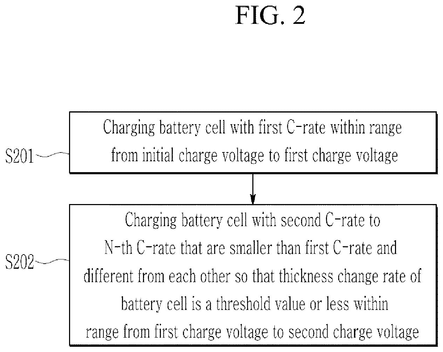

A method for charging the battery according to one or more embodiments will be described in more detail hereinafter with reference to FIG. 2 through FIG. 4.

FIG. 2 is a flowchart showing a method for charging a battery according to an embodiment.

Referring to FIG. 2, the method may start, and a battery cell may be charged with a first C-rate within a range from an initial charge voltage to a first charge voltage (S201). For example, the first charge unit 130 may charge the battery cell 10 with the first C-rate within the range from the initial charge voltage to the first charge voltage (S201).

In some embodiments, the battery cell 10 may include a negative electrode with a silicon (Si) content of 80% or more, and a positive electrode of nickel cobalt lithium aluminum acid (LiNixCoyAlza2, NCA). In more detail, the battery cell 10 may include a negative electrode including 80% or more of a silicon-based active material, or 50% or more of silicon.

The negative active material may include a suitable material that reversibly intercalates/de-intercalates lithium ions, a lithium metal, a lithium metal alloy, a suitable material capable of doping/de-doping lithium, or a transition metal oxide. The silicon-based negative active material may include silicon, a silicon-carbon composite, $SiO_x$ ($0 <_x < 2$), an Si-Q alloy (wherein Q is selected from an alkali metal, an alkaline-earth metal, a Group 13 element, a Group 14 element (except for Si), a Group 15 element, a Group 16 element, a transition metal, a rare earth element, and/or suitable combinations thereof), or a suitable combination thereof. The silicon-carbon composite may be a composite of silicon and amorphous carbon. As an example, the silicon-carbon composite may be in a form of silicon particles, and amorphous carbon coated on the surfaces of the silicon particles. For example, the silicon-carbon composite may include a secondary particle (e.g., a core) in which silicon primary particles are assembled, and an amorphous carbon coating layer (e.g., a shell) positioned on the secondary particle surface. The amorphous carbon may also be positioned between the silicon primary particles. For example, the silicon primary particles may be coated with the amorphous carbon. The secondary particles may be dispersed in an amorphous carbon matrix. The silicon-carbon composite may further include a crystalline carbon. For example, the silicon-carbon composite may include a core including crystalline carbon and silicon particles, and an amorphous carbon coating layer positioned on the surface of the core. The silicon-based negative active material may be used in a suitable combination with a carbon-based negative active material.

For example, the composition of the battery cell 10 may be defined by Table 1 below.

Table 1:

| Negative electrode | Silicon/graphite/carbon black/single-wall carbon nanotube (CNT)/acrylic binder/carboxymethylcellulose (CMC) 85.9/5.45/4/0.3/1.3/2.6 |
|---|---|
| Positive electrode | Nickel cobalt aluminum acid lithium (LiNixCoyAlzO2, NCA) |
| Electrolyte solution | 1.5M LiPF6, ethylene carbonate (EC)/ethylmethyl carbonate (EMC)/dimethyl carbonate (DMC)=20/10/70, 12.5% fluoroethyl |
| | carbonate (FEC), 0.2% LiBF4, 1% lithium bis (oxalato) borate (LiB C2O42: LiBOB), 0.25% succinonitrile (SN), 0.5% ethylene phosphorodifluoridite (C2H4F4O2P2), 1% lithium phosphorodifluoridate (LiPO2F2) |

The battery cell may be charged with a second C-rate to an N-th C-rate (where N is an integer of 3 or more) that are smaller than the first C-rate and different from each other so that a thickness change rate of the battery cell may be a threshold voltage or less within a range from the first charge voltage to a second charge voltage (S202). For example, the second charge unit 140 may charge the battery cell 10 with the second C-rate to the N-th C-rate that are smaller than the first C-rate and different from each other so that the thickness change rate of the battery cell 10 is the threshold value or less within the range from the first charge voltage to the second charge voltage (S202).

The second charge unit 140 may charge the battery cell 10 with an i-th C-rate (e.g., $2 \leq i \leq N-1$), and may charge the battery cell 10 with an (i+1)-th C-rate that is smaller than the i-th C-rate. Also, the second charge unit 140 may sequentially charge the battery cell 10 with the i-th C-rate and the (i+1)-th C-rate.

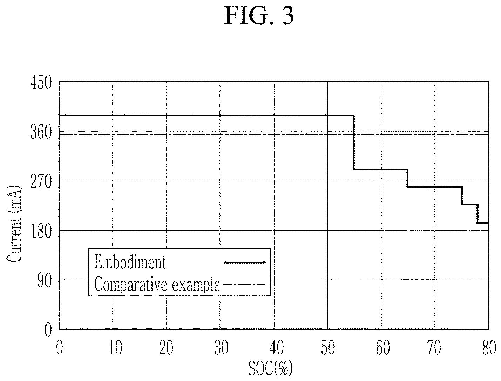

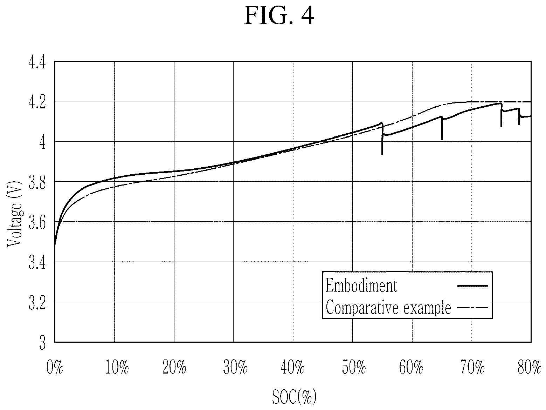

As an example, the method of charging the battery cell 10 is described in more detail below with reference to FIG. 3 and FIG. 4 and Table 2 to Table 4 below.

FIG. 3 is a graph showing a change in a current according to an SOC of a battery cell. FIG. 4 is a graph showing a change in a voltage according to an SOC of a battery cell.

Table 2 shows a charging method according to a comparative example, Table 3 shows a charging method according to an embodiment, and Table 4 shows a thickness change rate when charging and discharging the battery cell 10.

Hereinafter, for convenience, the battery cell 10 is assumed to be a single-panel pouch cell, and a capacity of 1C may be 65 mAh. The characteristics of the battery cell 10 described in more detail below may be based on a full cell evaluation.

Table 2:

| Sstep | C-rate (1C capacity = 65 mAh) | Current (mA) | Cut-off | Mode |
|---|---|---|---|---|
| 1 | 5.5C | 357.5 | SOC 80 | CC-CV |

According to the comparative example, the battery cell 10 is charged at 5.5C during a period when an SOC change value is 80. The charging of the battery cell 10 is performed using a constant current-constant voltage (CC-CV) method.

Table 3:

| Sstep | C-rate (1C capacity = 65 mAh) | Current (mA) | Cut-off | Mode |
|---|---|---|---|---|
| 1 | 6C | 390 | SOC 55 | CC |
| 2 | 4.5C | 292.5 | SOC 10 | CC |
| 3 | 4C | 260 | SOC 10 | CC |
| 4 | 3.5C | 227.5 | SOC 3 | CC |
| 5 | 3C | 195 | SOC 2 | CC |

According to an embodiment, the first charge unit 130 and the second charge unit 140 charge the battery cell 10 by a constant-current charging (CC) method.

The first charge unit 130 charges the battery cell 10 with the first C-rate of 6C within the range from the initial charge voltage to the first charge voltage, during the period when the SOC change value of the battery cell 10 is 55. The initial charge voltage may be a voltage in the range of 3.0V to 3.1V, and the first charge voltage may be in the range of 4.08V to 4.1V. The first C-rate may be 6C or higher.

The second charge unit 140 sequentially charges the battery cell 10 with the second C-rate to the fifth C-rate, which are smaller than the first C-rate and different from each other, for the thickness change rate of the battery cell 10 to be below the threshold value within the range from the first charge voltage to the second charge voltage. The second charge voltage may be in the range of 4.2V to 4.25V. The second charge unit 140 may charge the battery cell 10 so that the thickness change rate of the battery cell 10 is 65% or less. In more detail, the second charge unit 140 charges the battery cell 10 with the second C-rate of 4.5C during the period when the SOC change value of the battery cell 10 is 10. Next, the second charge unit 140 sequentially charges the battery cell 10 with the third C-rate of 4C during a period when the SOC change value of the battery cell 10 becomes 10, the fourth C-rate of 3.5C during a period when the SOC change value of the battery cell 10 becomes 3, and the fifth C-rate of 3C during a period when the SOC change value of the battery cell 10 becomes 2.

Referring to Table 4 below, the thickness change rate of the battery cell 10 charged through the charging method of the embodiment may be within 65%.

Table 4:

| | Thickness change rate |
|---|---|
| Embodiment | 60.5% |

(continued)

|  | Thickness change rate |
| --- | --- |
| Comparative Example | 70.8% |

The thickness change rate of the battery cell 10 may be the thickness change rate during one cycle of charging and discharging. One cycle may refer to sequentially performing a charging process, a rest process, a discharging process, and a rest process of the battery cell 10. For example, a reset time may be 10 minutes, and the discharging may be performed at 1C up to a discharge voltage of 3.1V. The thickness change rate of the battery cell 10 may be the thickness change rate when the voltage of the battery cell 10 changes in the range of 3.1V to 4.2V.

Referring to FIG. 4, according to the method for charging the battery according to the embodiment, it may be confirmed that an overvoltage generation may be prevented or substantially prevented compared to the charging method of the comparative example.

Referring to Table 5 below, during the period where the SOC is 0% to 80%, the charging time of the battery cell 10 according to the charging method of the embodiment may be maintained or substantially maintained similar to the charging time according to the charging method of the comparative example.

Table 5:

|  | SOC 80 charge time |
| --- | --- |
| Embodiment | 8 minutes, 28 seconds |
| Comparative example | 8 minutes, 30 seconds |

Also, referring to Table 6 below, when evaluating the life-cycle of 100 cycles, the life-cycle of the battery cell 10 according to the charging method of the embodiment may be improved compared to the life-cycle of the battery cell according to the charging method of the comparative example.

Table 6:

|  | Life-cycle maintenance rate |
| --- | --- |
| Embodiment | 94.71% |
| Comparative Example | 90.71% |

Also, referring to Table 7 below, when measuring the negative electrode thickness of the battery cell 10 after evaluating the life-cycle of 100 cycles, an increase rate of the negative electrode thickness of the battery cell 10 according to the charging method of the embodiment may be lower than the increase rate of the negative electrode thickness of the battery cell according to the charging method of the comparative example. The increase rate of the negative electrode thickness may refer to a ratio of the thickness of the negative electrode after 100 cycles of the life-cycle evaluation to the thickness of the negative electrode before the 100 cycles of the life-cycle evaluation.

Table 7:

|  | Negative electrode thickness increase rate |
| --- | --- |
| Embodiment | 146.47% |
| Comparative Example | 166.10% |

As another example, the charging method of the battery cell 10 is described in more detail below with reference to Table 8. Table 8 shows a charging method according to another embodiment.

Table 8:

| Sstep | C-rate (1C capacity = 65 mAh) | Current (mA) | Cut-off | Mode |
| --- | --- | --- | --- | --- |
| 1 | 6C | 390 | SOC 55 | CC |
| 2 | 4.5C | 292.5 | SOC 10 | CC |

(continued)

| Sstep | C-rate (1C capacity = 65 mAh) | Current (mA) | Cut-off | Mode |
|---|---|---|---|---|
| 3 | 4C | 260 | SOC 10 | CC |
| 4 | 3.5C | 227.5 | SOC 5 | CC |

According to the present embodiment, the first charge unit 130 and the second charge unit 140 may charge the battery cell 10 by the constant-current charging (CC) method.

The first charge unit 130 charges the battery cell 10 with the first C-rate of 6C during the period when the SOC change value of the battery cell 10 is 55 within a range from the initial charge voltage to the first charge voltage. The initial charge voltage may be included in the range of 3.0V to 3.1V, and the first charge voltage may be in the range of 4.08V to 4.1V. The first C-rate may be 6C or higher.

The second charge unit 140 sequentially charges the battery cell 10 with the second C-rate to the fifth C-rate, which are smaller than the first C-rate and different from each other, so that the thickness change rate of the battery cell 10 is the threshold value or less in the range from the first charge voltage to the second charge voltage. The second charge voltage may be in the range of 4.2V to 4.25V. The second charge unit 140 may charge the battery cell 10 so that the thickness change rate of the battery cell 10 is 65% or less. In more detail, the second charge unit 140 charges the battery cell 10 with the second C-rate of 4.5C during the period when the SOC change value of the battery cell 10 is 10. Also, the second charge unit 140 sequentially charges the battery cell 10 with the third C-rate of 4C during the period when the SOC change value of the battery cell 10 becomes 10, and the fourth C-rate of 3.5C during the period when the SOC change value of the battery cell 10 becomes 5.

As another example, the charging method of the battery cell 10 is described in more detail below with reference to Table 9. Table 9 shows the charging method according to another embodiment.

Table 9:

| Sstep | C-rate (1C capacity = 65 mAh) | Current (mA) | Cut-off | Mode |
|---|---|---|---|---|
| 1 | 6C | 390 | SOC 55 | CC |
| 2 | 4.5C | 292.5 | SOC 10 | CC |
| 3 | 4C | 260 | SOC 10 | CC |
| 4 | 3C | 227.5 | SOC 5 | CC |

According to the present embodiment, the first charge unit 130 and the second charge unit 140 may charge the battery cell 10 by a constant-current charging (CC) method.

The first charge unit 130 may charge the battery cell 10 with the first C-rate of 6C within a range from the initial charge voltage to the first charge voltage, during the period when the SOC change value of the battery cell 10 is 55. The initial charge voltage may be in the range of 3.0V to 3.1V, and the first charge voltage may be in the range of 4.08V to 4.1V. The first C-rate may be 6C or higher.

Within the range from the first charge voltage to the second charge voltage, the second charge unit 140 may sequentially charge the battery cell 10 with the second C-rate to the fifth C-rate, which are smaller than the first C-rate and different from each other, so that the thickness change rate of the battery cell 10 is the threshold value or less. The second charge voltage may be within the range of 4.2V to 4.25V. The second charge unit 140 may charge the battery cell 10 so that the thickness change rate of the battery cell 10 is 65% or less. In more detail, the second charge unit 140 may charge the battery cell 10 with the second C-rate of 4.5C during the period when the SOC change value of the battery cell 10 is 10. Also, the second charge unit 140 may sequentially charge the battery cell 10 with the third C-rate of 4C during the period when the SOC change value of the battery cell 10 becomes 10, and the fourth C-rate of 3C during the period when the SOC change value of the battery cell 10 becomes 5.

Table 10 shows the thickness change rate during the charging and discharging of the battery cell 10 according to another embodiment, and a charging method according to another embodiment.

Referring to Table 10 below, the thickness change rate of the battery cell 10 charged through the charging method of the present embodiment may be within 65%.

Referring to Table 10 below, the thickness change rate of the battery cell 10 charged through the charging method according to the present embodiment may be within the range of 60% to 63%, and in more detail, within the range of 60.5% to 62.2%. By charging the battery cell 10 in stages through the charging method of present embodiment, unlike the case of the comparative example, the battery cell 10 may be charged so that the thickness change rate of the battery cell 10 is within 65%.

Table 10:

|  | Thickness change rate |
| --- | --- |
| Another embodiment | 62.1% |
| Another embodiment | 62.2% |
| Comparative Example | 70.8% |

Therefore, by charging the battery cell 10 by the charging method according to one or more embodiments of the present disclosure, the deterioration of the silicon negative electrode may be suppressed by lowering the overvoltage through a step-by-step charging, a rapid expansion of the silicon negative electrode may be reduced, the battery life-cycle may be improved, and the energy density and high-rate charging performance of the battery having high-content silicon may be prevented or substantially prevented from being deteriorated.

The electronic or electric devices and/or any other relevant devices or components according to embodiments of the present disclosure described herein (e.g., the MCU, the sensing unit, the first charge unit, and/or the second charge unit) may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

For example, the sensing unit 120 may include a sensing device, which may include or may be a thermistor which measures temperature by using the characteristic that resistance increases or decreases with temperature (e.g., a positive temperature coefficient thermistor (PTC) or negative temperature coefficient thermistor (NTC)) for sensing temperature of the battery cell and may generate and output electric signals corresponding to temperature information of the battery cell. In one example, the first charging portion 130 may generate a charging current (and/or voltage) utilizing a voltage supplied from the input end, and supply the generated current to the battery cell 10 via a diode and a switch. The second charging portion 140 may generate a charging current (and/or voltage) utilizing a voltage supplied from the input end, and supply the generated current to the battery cell 10 via a diode and a switch.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

**Description of symbols**

10: battery cell
100: battery management system
110: MCU (micro control unit)
120: sensing unit

130: first charge unit
140: second charge unit

## Claims

1. A method for charging a battery, comprising:

    charging a battery cell with a first C-rate within a range from an initial charge voltage to a first charge voltage; and charging the battery cell with a second C-rate to an N-th C-rate, which are smaller than first C-rate and different from each other, so that a thickness change rate of the battery cell is a threshold value or less within a range from the first charge voltage to a second charge voltage, where N is an integer greater than or equal to 3.

2. The method for charging the battery of claim 1, wherein the charging of the battery cell with the second C-rate to the N-th C-rate comprises:

    charging the battery cell with an i-th C-rate, where i is greater than or equal to 2 and less than or equal to N-1; and charging the battery cell with an (i+1)-th C-rate that is smaller than the i-th C-rate, and optionally wherein the charging of the battery cell with the i-th C-rate and the charging of the battery cell with the (i+1)-th C-rate are sequentially performed.

3. The method for charging the battery of claim 1 or claim 2, wherein the first charge voltage is in a range of 4.08V to 4.1V, and/or the second charge voltage is in a range of 4.2V to 4.25V.

4. The method for charging the battery of any one of the preceding claims, wherein the thickness change rate of the battery cell is a ratio of a difference between a first thickness of the battery cell, measured while applying a pressure to the battery cell at the initial charge voltage, and a second thickness of the battery cell, measured while applying a pressure to the battery cell at the second charge voltage, to the first thickness of the battery cell.

5. The method for charging the battery of any one of the preceding claims, wherein the battery cell comprises a negative electrode comprising 80% or more of a silicon-based active material, or 50% or more of silicon.

6. The method for charging the battery of any one of the preceding claims, wherein the initial charge voltage is in a range of 3.0V to 3.1V.

7. The method for charging the battery of any one of the preceding claims, wherein the thickness change rate of the battery cell is 65% or less.

8. The method for charging the battery of any one of the preceding claims, wherein the charging of the battery cell with the first C-rate and the charging of the battery cell with the second C-rate to the N-th C-rate comprise charging the battery cell by a constant-current (CC) charging method.

9. A battery management system comprising:

    a first charger configured to charge a battery cell with a first C-rate within a range from an initial charge voltage to a first charge voltage; and
    a second charger configured to charge the battery cell from a second C-rate to an N-th C-rate, which are smaller than the first C-rate and different from each other, so that a thickness change rate of the battery cell is a threshold value or less within a range from the first charge voltage to a second charge voltage.

10. The battery management system of claim 9, wherein the second charger is configured to charge the battery cell with an i-th C-rate, where i is greater than or equal to 2 and less than or equal to N-1, and charge the battery cell with an (i+1)-th C-rate smaller than the i-th C-rate, and optionally wherein the second charger is configured to sequentially charge the battery cell with the i-th C-rate and the (i+1)-th C-rate.

11. The battery management system of claim 9 or claim 10, wherein the first charge voltage is in a range of 4.08V to 4.1V, and/or the second charge voltage is in a range of 4.2V to 4.25V.

12. The battery management system of any one of claims 9 to 11, wherein the thickness change rate of the battery cell is a ratio of a difference between a first thickness of the battery cell measured while applying a pressure to the battery cell at the initial charge voltage and a second thickness of the battery cell measured while applying a pressure to the battery cell at the second charge voltage to the first thickness of the battery cell.

13. The battery management system of any one of claims 9 to 12, wherein the battery cell comprises a negative electrode comprising 80% or more of a silicon-based active material, or 50% or more of silicon.

14. The battery management system of any one of claims 9 to 13, wherein the initial charge voltage is in a range of 3.0V to 3.1V, and/or the thickness change rate of the battery cell is 65% or less.

15. The battery management system of any one of claims 8 to 14, wherein the first charger and the second charger are configured to charge the battery cell by a constant-current (CC) charge method.

# FIG. 1

# FIG. 2

S201 — Charging battery cell with first C-rate within range from initial charge voltage to first charge voltage

S202 — Charging battery cell with second C-rate to N-th C-rate that are smaller than first C-rate and different from each other so that thickness change rate of battery cell is a threshold value or less within range from first charge voltage to second charge voltage

# FIG. 3

## FIG. 4

Europäisches
Patentamt

European
Patent Office

Office européen
des brevets

# EUROPEAN SEARCH REPORT

**Application Number**

EP 24 18 5930

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2015/340885 A1 (BAEK HO-YUL [KR] ET AL) 26 November 2015 (2015-11-26) * paragraphs [0053] - [0109]; figures 1-7 * | 1-15 | INV. H02J7/00 H01M10/44 |
| Y | US 2018/123354 A1 (LIM JU WAN [KR] ET AL) 3 May 2018 (2018-05-03) * paragraphs [0051] - [0067]; figures 1-3 * | 1-15 | |
| Y | US 2022/271537 A1 (MIKHAYLIK YURIY V [US] ET AL) 25 August 2022 (2022-08-25) * paragraphs [0170] - [0172], [0178] * | 1-15 | |

TECHNICAL FIELDS
SEARCHED    (IPC)

H02J
H01M

The present search report has been drawn up for all claims

| Place of search | Date of completion of the search | Examiner |
|---|---|---|
| Munich | 16 December 2024 | Telega, Pawel |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.......................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 18 5930

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2024

| Patent document cited in search report | Publication date | Patent family member(s) | | Publication date |
|---|---|---|---|---|
| US 2015340885 A1 | 26-11-2015 | BR | 102015011495 A2 | 06-03-2018 |
| | | CN | 105098876 A | 25-11-2015 |
| | | EP | 2947748 A1 | 25-11-2015 |
| | | KR | 20150133587 A | 30-11-2015 |
| | | US | 2015340885 A1 | 26-11-2015 |
| US 2018123354 A1 | 03-05-2018 | CN | 108023375 A | 11-05-2018 |
| | | EP | 3316446 A1 | 02-05-2018 |
| | | US | 2018123354 A1 | 03-05-2018 |
| | | US | 2021210971 A1 | 08-07-2021 |
| US 2022271537 A1 | 25-08-2022 | JP | 2024506589 A | 14-02-2024 |
| | | KR | 20230155443 A | 10-11-2023 |
| | | US | 2022271537 A1 | 25-08-2022 |
| | | US | 2022336872 A1 | 20-10-2022 |
| | | WO | 2022169980 A1 | 11-08-2022 |

EPO FORM P0459

For more details about this annex : see Official Journal of the European Patent Office, No. 12/82